# EUROPEAN PATENT SPECIFICATION

(11) **EP 4 380 047 B1**
(45) Date of publication and mention of the grant of the patent: **31.12.2025**
(21) Application number: 23832944.5
(22) Date of filing: 11.10.2023
(51) Int. Cl.: H03F 1/52, H03F 3/189, H04B 17/10, H03F 3/19, H03F 3/24, H04B 1/04, H03F 3/195

(54) **ELECTRONIC DEVICE COMPRISING POWER AMPLIFIER, AND OPERATING METHOD THEREOF**
ELEKTRONISCHE VORRICHTUNG MIT LEISTUNGSVERSTÄRKER UND BETRIEBSVERFAHREN DAFÜR
DISPOSITIF ÉLECTRONIQUE COMPRENANT UN AMPLIFICATEUR DE PUISSANCE ET SON PROCÉDÉ DE FONCTIONNEMENT

(30) Priority: 14.10.2022 KR 20220132578; 07.11.2022 KR 20220147090
(43) Date of publication of application: 05.06.2024
(73) Proprietor: Samsung Electronics Co., Ltd., Suwon-si, Gyeonggi-do 16677 (KR)
(72) Inventor: MOON, John, Suwon-si, Gyeonggi-do 16677 (KR); NA, Hyoseok, Suwon-si, Gyeonggi-do 16677 (KR); YANG, Dongil, Suwon-si, Gyeonggi-do 16677 (KR); LEE, Doohwan, Suwon-si, Gyeonggi-do 16677 (KR)
(74) Representative: Arnold & Siedsma
(86) International application number: PCT/KR2023/015591
(87) International publication number: WO 2024/080724

(56) References cited:
- KR-A- 20110 031 362
- KR-A- 20140 042 569
- KR-A- 20180 119 305
- KR-A- 20210 075 834
- US-A- 3 641 451
- US-A- 4 353 037
- US-A1- 2007 298 735
- US-A1- 2014 368 280

## Description

### [Technical Field]

Various embodiments of this document relate to an electronic device, for example, an electronic device including a power amplifier and a method of operating the same.

### [Background Art]

Various electronic devices such as a smart phone, a tablet personal computer (PC), a portable multimedia player (PMP), a personal digital assistant (PDA), a laptop personal computer (laptop PC), or a wearable device are being widespread.

Recent electronic devices may support a communication method (e.g., dual connectivity or carrier aggregation) using a plurality of frequency bands. A communication method using a plurality of frequency bands may have a larger frequency bandwidth than that of a communication method using a single frequency band. A communication method using a plurality of frequency bands having a relatively large frequency bandwidth may implement a higher data transmission rate or reception rate than that of other communication methods.

An electronic device may include a plurality of communication circuits (e.g., transceiver or amplifier circuit) for performing communication in each frequency band in order to support a communication method using a plurality of frequency bands. The communication circuit may include an amplifier circuit for amplifying a signal to be transmitted. The amplifier circuit may amplify a signal using power supplied by the power supply circuit. In the case that a voltage applied to the amplifier circuit is too high, the amplifier circuit may be damaged. Accordingly, the amplifier circuit may include an overvoltage protection circuit for preventing an excessively high voltage from being applied thereto. The overvoltage protection circuit may operate in the form of cutting off an operation of a specific bias when an internal voltage of the electronic device exceeds (or more than) a designated value.

US4353037A1 discloses a protection circuit for a transmitter amplifier which provides power leveling and controls transmitter output power as a function of the ratio of reflected power to forward power. The circuit senses forward power level and develops a first voltage which is compared with the reference voltage to provide a control voltage which controls the power developed by the transmitter amplifier. Reflected power is sensed and a second voltage is developed which is compared to a portion of the first voltage and causes a reduction in the reference voltage when the reflected power to forward power ratio exceeds a predetermined level.

US2007/298735A1 discloses a system and method of feedback transmitter power control including a transmitter temperature detector such as a thermistor based temperature detector, a detector for detecting forward and reflected transmitter power, and a voltage controlled attenuator placed in a radio frequency power control feedback path for modifying transmitter power based on a detected transmitter temperature and a detected forward and reflected transmitter power. The system further includes a logarithmic amplifier controller in the feedback path coupled to the voltage controlled attenuator as well as a power amplifier coupled to the voltage controlled attenuator. The system can operate in both analog and time division multiple access modes. The system can be active in real time throughout a push-to-talk session.

US3641451A1 discloses a protection circuit for a transmitter amplifier which senses the forward power level and develops a first voltage which is compared with a reference voltage to provide a control voltage which controls the power developed by the transmitter amplifier. Increase in the forward power level is detected changing the control voltage to cause a reduction in the forward power developed by the transmitter amplifier. Decrease in forward power level is detected changing the control voltage to cause an increase in forward power developed by the transmitter amplifier. Reflected power is sensed developing a second voltage which causes a reduction in reference voltage when reflected power exceeds a predetermined level. Reduction of the reference voltage also changes the control voltage to reduce the forward power of the transmitter amplifier to a safe level. An increase in transmitter amplifier temperature beyond a predetermined level is sensed causing a reduction in the reference voltage to change the control voltage thereby reducing the power of the transmitter amplifier to a safe level.

### [Disclosure of Invention]

### [Technical Problem]

Damage (or loss) of a power amplifier or amplifier circuit may be determined by at least one of a magnitude of a voltage Vcc connected to a collector terminal of the power amplifier or amplifier circuit, a magnitude of input power, or a magnitude of a voltage standing wave ratio of an antenna terminal. The voltage standing wave may mean a wave observed as only oscillating in place without moving left and right by a combination of an incident wave and a reflected wave. A voltage standing wave ratio may mean an amplitude ratio between a maximum point and a minimum point of an oscillating voltage standing wave. The voltage standing wave ratio of an antenna terminal may mean the degree to which a signal is reflected back without being transmitted to the antenna when a signal is input to the antenna. The overvoltage protection circuit may prevent damage under one variable condition, such as the magnitude of the voltage Vcc, but it may be difficult for the overvoltage protection circuit to prevent damage under complex absolute maximum rating (AMR) conditions in which the aforementioned multiple variables operate simultaneously.

### [Solution to Problem]

According to an aspect of the present disclosure, an electronic device as defined in any of the appended claims 1-10 is provided.

According to another aspect of the present disclosure, a method as defined in any of the appended claims 11-15 is provided.

### [Advantageous Effects of Invention]

According to an embodiment, in order to prevent damage of an amplifier circuit, the electronic device can change an operating condition of an OVP circuit according to a VSWR of an antenna terminal. The VSWR of the antenna terminal may mean the degree to which a signal is reflected back without being transmitted to the antenna when a signal is input to the antenna. Specifically, the electronic device can change a magnitude of a voltage applied to the amplifier in which the OVP circuit may operate according to the VSWR. Accordingly, the electronic device can prevent damage of a power amplifier or an amplifier circuit.

According to an embodiment, the electronic device can determine a magnitude of a voltage at which an OVP circuit operates with reference to mapping data in which a magnitude of a VSWR and a magnitude of a voltage at which an OVP device operates are mapped. Therefore, the electronic device can adaptively adjust a magnitude of a voltage at which the OVP circuit operates, thereby preventing damage of the power amplifier or the amplifier circuit.

### [Brief Description of Drawings]

FIG. 1 is a block diagram illustrating an electronic device in a network environment according to an embodiment.
FIG. 2 is a block diagram illustrating an electronic device for supporting legacy network communication and 5G network communication according to an embodiment.
FIG. 3 is a block diagram illustrating an electronic device according to an embodiment.
FIG. 4 illustrates an overvoltage protection circuit according to an embodiment.
FIG. 5 is a circuit diagram illustrating an amplifier circuit in an electronic device according to an embodiment.
FIG. 6 illustrates I/Q plot data corresponding to a voltage standing wave ratio (VSWR) of an electronic device according to an embodiment.
FIG. 7 is a flowchart illustrating a method of controlling an amplifier circuit of an electronic device according to an embodiment.
FIG. 8 is a flowchart illustrating a method of controlling an amplifier circuit of an electronic device according to an embodiment.

### [Mode for the Invention]

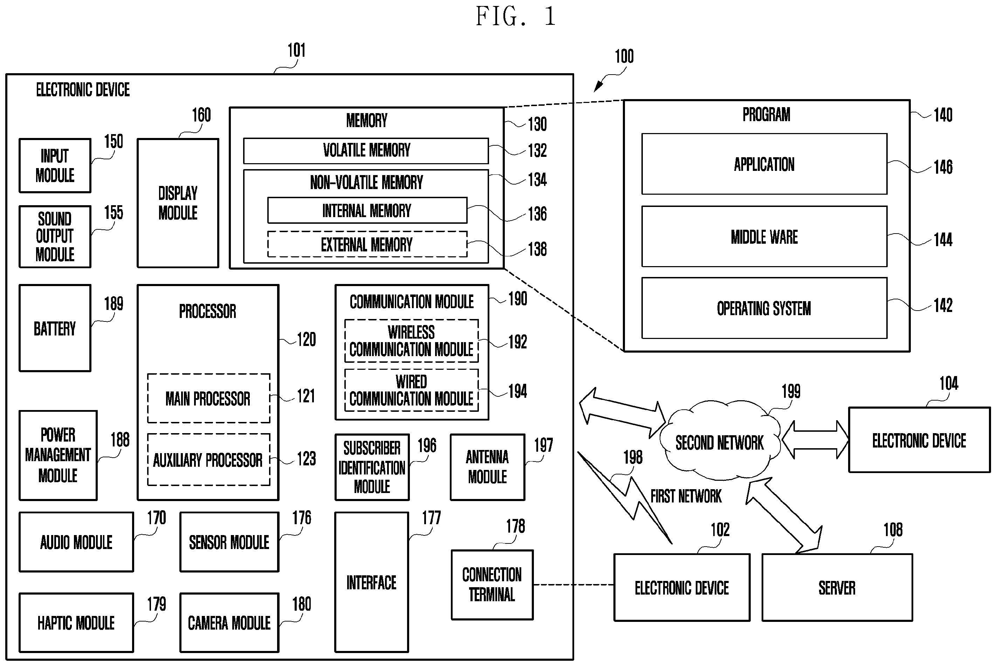

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multipleoutput (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

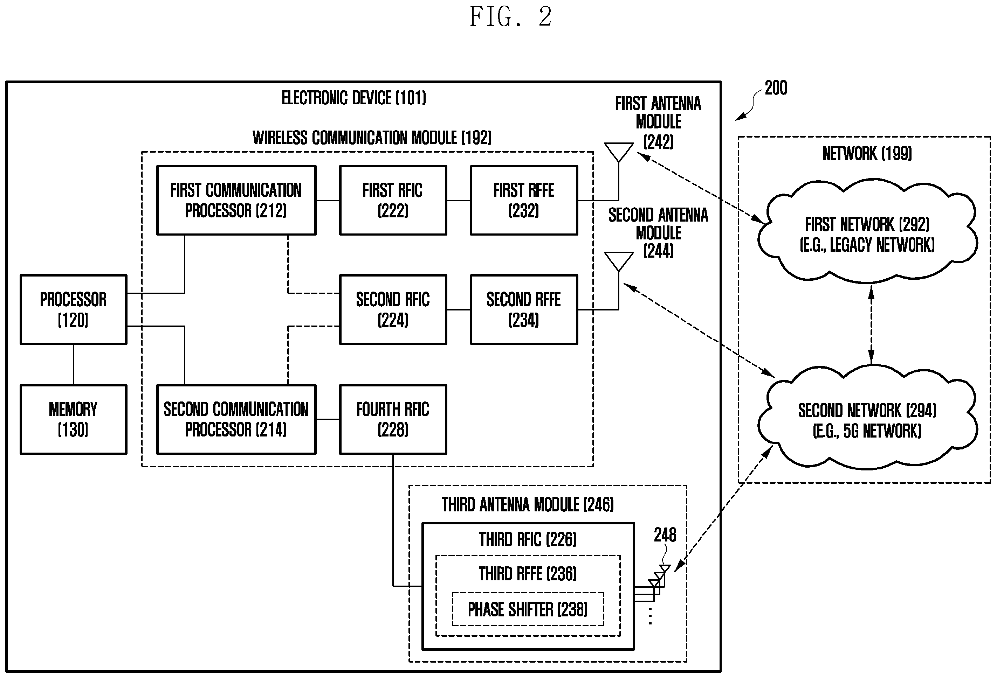

FIG. 2 is a block diagram 200 illustrating an electronic device 101 for supporting legacy network communication and 5G network communication according to an embodiment. With reference to FIG. 2, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, and an antenna 248. The electronic device 101 may further include a processor 120 and a memory 130. A network 199 may include a first network 292 and a second network 294. According to another embodiment, the electronic device 101 may further include at least one of the components illustrated in FIG. 1, and the network 199 may further include at least one another network. According to an embodiment, the first communication processor 212, the second communication processor 214, the first RFIC 222, the second RFIC 224, the fourth RFIC 228, the first RFFE 232, and the second RFFE 234 may form at least a part of the wireless communication module 192. According to another embodiment, the fourth RFIC 228 may be omitted or included as part of the third RFIC 226.

The first communication processor 212 may establish a communication channel of a band to be used for wireless communication with the first network 292 and support legacy network communication through the established communication channel. According to an embodiment, the first network may be a legacy network including a second generation (2G), 3G, 4G, or long term evolution (LTE) network. The second communication processor 214 may establish a communication channel corresponding to a designated band (e.g., about 6 GHz to about 60 GHz) among bands to be used for wireless communication with the second network 294, and support 5G network communication through the established communication channel. According to an embodiment, the second network 294 may be a 5G network defined in 3GPP. Additionally, according to an embodiment, the first communication processor 212 or the second communication processor 214 may establish a communication channel corresponding to another designated band (e.g., about 6 GHz or less) among bands to be used for wireless communication with the second network 294 and support 5G network communication through the established communication channel. According to an embodiment, the first communication processor 212 and the second communication processor 214 may be implemented in a single chip or a single package. According to an embodiment, the first communication processor 212 or the second communication processor 214 may be formed with the processor 120, coprocessor 123, or communication module 190 in a single chip or a single package.

During transmission, the first RFIC 222 may convert a baseband signal generated by the first communication processor 212 into a radio frequency (RF) signal of about 700 MHz to about 3 GHz used in the first network 292 (e.g., legacy network). During reception, an RF signal may be acquired from the first network 292 (e.g., legacy network) through the antenna (e.g., the first antenna module 242), and be preprocessed through an RFFE (e.g., the first RFFE 232). The first RFIC 222 may convert the preprocessed RF signal into a baseband signal to be processed by the first communication processor 212.

During transmission, the second RFIC 224 may convert a baseband signal generated by the first communication processor 212 or the second communication processor 214 into an RF signal (hereinafter, 5G Sub6 RF signal) of a Sub6 band (e.g., about 6 GHz or less) used in the second network 294 (e.g., 5G network). During reception, a 5G Sub6 RF signal may be acquired from the second network 294 (e.g., 5G network) through the antenna (e.g., the second antenna module 244), and be preprocessed through an RFFE (e.g., the second RFFE 234). The second RFIC 224 may convert the preprocessed 5G Sub6 RF signal into a baseband signal to be processed by a corresponding communication processor among the first communication processor 212 or the second communication processor 214.

The third RFIC 226 may convert a baseband signal generated by the second communication processor 214 into the RF signal (hereinafter, 5G Above6 RF signal) of the 5G Above 6 band (e.g., about 6 GHz to about 60 GHz) to be used in the second network 294 (e.g., 5G network). During reception, the 5G Above6 RF signal may be acquired from the second network 294 (e.g., 5G network) through the antenna (e.g., the antenna 248) and be preprocessed through a third RFFE 236. The third RFIC 226 may convert the preprocessed 5G Above6 RF signal into a baseband signal to be processed by the second communication processor 214. According to an embodiment, the third RFFE 236 may be formed as part of the third RFIC 226.

According to an embodiment, the electronic device 101 may include a fourth RFIC 228 separately from or at least as part of the third RFIC 226. In this case, the fourth RFIC 228 may convert a baseband signal generated by the second communication processor 214 into an RF signal (hereinafter, IF signal) of an intermediate frequency band (e.g., about 9 GHz to about 11 GHz) and then transmit the IF signal to the third RFIC 226. The third RFIC 226 may convert the IF signal into a 5G Above6 RF signal. During reception, the 5G Above6 RF signal may be received from the second network 294 (e.g., 5G network) through the antenna (e.g., the antenna 248) and be converted to an IF signal by the third RFIC 226. The fourth RFIC 228 may convert the IF signal into a baseband signal so that the second communication processor 214 may process the IF signal.

According to an embodiment, the first RFIC 222 and the second RFIC 224 may be implemented into at least part of a single chip or a single package. According to an embodiment, the first RFFE 232 and the second RFFE 234 may be implemented into at least part of a single chip or a single package. According to an embodiment, at least one antenna module of the first antenna module 242 or the second antenna module 244 may be omitted or combined with another antenna module to process RF signals of a plurality of corresponding bands.

According to an embodiment, the third RFIC 226 and the antenna 248 may be disposed in the same substrate to form a third antenna module 246. For example, the wireless communication module 192 or processor 120 may be disposed in a first substrate (e.g., main PCB). In this case, the third RFIC 226 may be disposed in a partial area (e.g., lower surface) of a second substrate (e.g., sub PCB) separate from the first substrate, and the antenna 248 may be disposed in another partial area (e.g., upper surface) of the second substrate (e.g., sub PCB), thereby forming the third antenna module 246. By disposing the third RFIC 226 and the antenna 248 in the same substrate, it is possible to reduce a length of a transmission line therebetween. This, for example, may reduce a loss (e.g., attenuation) of a signal of a high frequency band (e.g., about 6 GHz to about 60 GHz) used in 5G network communication by a transmission line. Thereby, the electronic device 101 may improve a quality or speed of communication with the second network 294 (e.g., 5G network).

According to an embodiment, the antenna 248 may be formed with an antenna array including a plurality of antenna elements that may be used for beamforming. In this case, the third RFIC 226 may include, for example, a plurality of phase shifters 238 corresponding to a plurality of antenna elements as a part of the third RFFE 236. During transmission, each of the plurality of phase shifters 238 may convert a phase of a 5G Above6 RF signal to be transmitted to the outside (e.g., a base station of a 5G network) of the electronic device 101 through a corresponding antenna element. During reception, each of the plurality of phase shifters 238 may convert a phase of the 5G Above6 RF signal received from the outside through the corresponding antenna element into the same or substantially the same phase. This enables transmission or reception through beamforming between the electronic device 101 and the outside.

The second network 294 (e.g., 5G network) may be operated independently of the first network 292 (e.g., legacy network) (e.g., standalone (SA)) or may be operated in connection with the first network 292 (e.g., non-standalone (NSA)). For example, the 5G network may include only an access network (e.g., 5G radio access network (RAN) or next generation RAN (NG RAN)) and no core network (e.g., next generation core (NGC)). In this case, after accessing the access network of the 5G network, the electronic device 101 may access an external network (e.g., Internet) under the control of a core network (e.g., evolved packed core (EPC)) of the legacy network. Protocol information (e.g., LTE protocol information) for communication with the legacy network or protocol information (e.g., new radio (NR) protocol information) for communication with the 5G network may be stored in the memory 130 to be accessed by other components (e.g., the processor 120, the first communication processor 212, or the second communication processor 214).

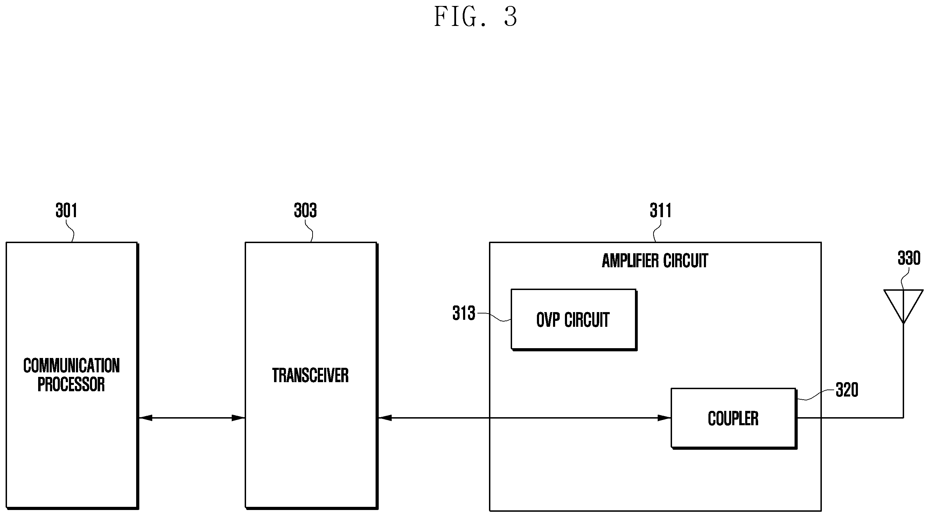

FIG. 3 is a block diagram illustrating an electronic device according to an embodiment of the disclosure.

With reference to FIG. 3, the electronic device (e.g., the electronic device 101 of FIG. 1) according to an embodiment of the disclosure may include a communication processor 301 (e.g., the first communication processor 212 or the second communication processor 214 of FIG. 2), a transceiver 303 (e.g., the first RFIC 222, the second RFIC 224, the third RFIC 226, or the fourth RFIC 228 of FIG. 2), an amplifier circuit 311, and an antenna 330 (e.g., the first antenna module 242, the second antenna module 244, or the third antenna module 246 of FIG. 2). The amplifier circuit 311 may include an overvoltage protection (OVP) circuit 313 and a coupler 320.

According to an embodiment, the coupler 320 may be included inside the amplifier circuit 311. The coupler 320 may acquire a part of a signal output from the amplifier circuit 311 and transmit it to the transceiver 303.

According to an embodiment, the communication processor 301 may receive and/or transmit control data or user data through short range wireless communication (e.g., Wi-Fi or Bluetooth) or cellular wireless communication (e.g., 4th generation mobile communication or 5th generation mobile communication). The communication processor 301 may establish a cellular communication connection with the base station through control data, transmit data received from the application processor (e.g., the processor 120 of FIG. 1) to the base station through the established cellular communication, and/or transmit data received from the base station to an application processor (e.g., the processor 120 of FIG. 1).

According to an embodiment, the transceiver 303 may perform a series of operations of processing signals received from the communication processor 301. For example, the transceiver 303 may perform a modulation operation of a signal received from the communication processor 301. For example, the transceiver 303 may perform a frequency modulation operation of converting a baseband signal into a radio frequency (RF) signal to be used for cellular communication. The transceiver 303 may perform a demodulation operation of a signal received from the outside through a communication circuit. For example, the transceiver 303 may perform a frequency demodulation operation of converting a radio frequency (RF) signal into a baseband signal.

According to an embodiment, the electronic device 101 may include at least one RF chain for outputting a signal of a first frequency band through a first antenna (e.g., the antenna 330). For example, the RF chain may mean a set of components included in a movement path of a signal. The RF chain may include, for example, components (e.g., amplifier, switch, or filter) that perform an operation of amplifying a signal of the first frequency band transmitted by the transceiver 303 and filtering the amplified signal.

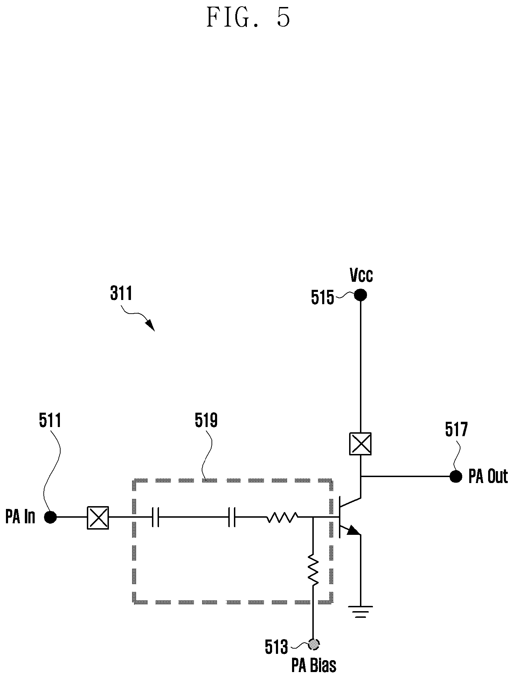

According to an embodiment, the electronic device 101 may include an amplifier circuit 311 for amplifying a signal of a specific frequency band. The amplifier circuit 311 may be a component included in the RF chain. The RF chain may mean a set of components included in a signal movement path. The RF chain may include, for example, components (e.g., amplifier, switch, or filter) that perform an operation of amplifying a signal of a specific frequency band transmitted by the transceiver 303 and filtering the amplified signal. The amplifier circuit 311 may include at least one amplifier for amplifying signals of a specific frequency band. For example, the amplifier circuit 311 may be implemented into a multi-stage amplifier structure for amplifying a signal of a specific frequency band in several steps. The amplifier circuit 311 will be described with reference to FIG. 5.

According to an embodiment, the communication processor 301 may measure the magnitude of the voltage standing wave ratio (VSWR) of the amplifier circuit 311 using the transceiver 303 and the coupler 320. The coupler 320 is a passive element and may be used for extracting a signal that measures the magnitude of the VSWR. The coupler 320 may be used for distributing one signal power into a plurality of specific signal powers or may be used for extracting some of specific signal power. According to an example, the coupler 320 may acquire a part of a signal output from the amplifier circuit 311 to the antenna 330 and transmit the acquired signal to the transceiver 303. The transceiver 303 may convert the received signal and transmit the signal to the communication processor 301. The communication processor 301 may determine the VSWR of the signal output to the antenna 330 based on the signal received from the transceiver 303.

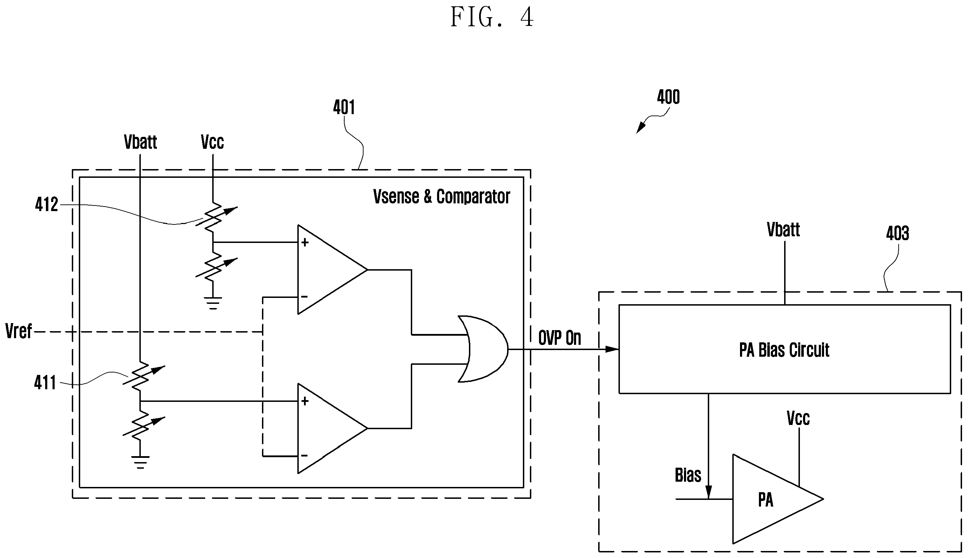

FIG. 4 illustrates an OVP circuit according to an embodiment.

The electronic device (e.g., the electronic device 101 of FIG. 1) may include an OVP circuit 400. The OVP circuit 400 may be included in an amplifier circuit (e.g., the amplifier circuit 311 of FIG. 3). The OVP circuit 400 may include a comparator 401 for comparing a voltage Vbatt of the battery and a voltage Vcc of a collector terminal with a reference voltage Vref. The OVP circuit 400 may include a voltage controller 403 for measuring the voltage Vbatt of the battery and the voltage Vcc of the collector terminal and turning off the voltage applied to the amplifier circuit 311 based on a specific signal. According to the comparative example, the communication processor (e.g., the communication processor 301 of FIG. 3) may turn off the voltage applied to the amplifier circuit 311 in the voltage controller 403 based on the voltage Vbatt of the battery and/or the voltage Vcc of the collector terminal exceeding the reference voltage Vref. However, damage to an electronic element (e.g., the power amplifier or amplifier circuit 311) may occur even when the voltage Vbatt of the battery and the voltage Vcc of the collector terminal are less than the reference voltage Vref in a situation in which the VSWR of the signal output to the antenna exceeds a designated level. The VSWR may mean a ratio of a height of a voltage standing wave generated by partially reflecting when the signal is output to an antenna. The VSWR of the antenna terminal may mean the degree to which a signal is reflected back without being transmitted to the antenna when a signal is input to the antenna. As the VSWR of the antenna terminal increases, the effect of the reflected wave on the output of the antenna may increase relatively. As the VSWR increases, the possibility of occurrence of damage due to the effect of the reflected wave may relatively increase.

The electronic device 101 according to the embodiments of this document may change the reference voltage Vref of the OVP circuit 400 based on the magnitude of the VSWR of the antenna terminal. The electronic device 101 may reduce the possibility of occurrence of damage without lowering the output of the amplifier circuit 311 or lowering the voltage Vcc of the collector terminal. Alternatively, the electronic device 101 may change the reference voltage Vref of the OVP circuit 400 based on a parameter (e.g., reflection coefficient, transmission coefficient or a return loss) indicating the degree of signals output to the antenna (e.g., the antenna 330 of FIG. 3), but reflected in the amplifier circuit 311.

According to an embodiment, the communication processor (e.g., the processor 301 of FIG. 3) may acquire information on a VSWR, which is a ratio between the intensity of a signal output to the antenna 330 and the intensity of the signal reflected without being transmitted to the antenna 330 when the signal is transmitted to the antenna 330 using the coupler (e.g., the coupler 320 of FIG. 3). According to an example, the communication processor 301 may identify the intensity of the reflected signal acquired using the coupler 320. The communication processor 301 may receive the intensity of the amplified signal from the amplifier circuit 311. The communication processor 301 may identify the VSWR based on a ratio between the intensity of the amplified signal and the intensity of the reflected signal.

The communication processor 301 may determine to change (or decrease) the reference voltage based on the VSWR being equal to or greater than (or exceeding) a designated value.

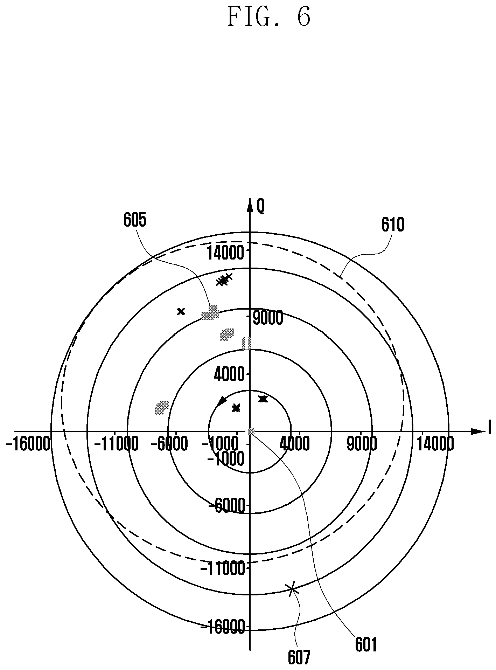

Information on the VSWR may be converted into I/Q plot data displayed by dividing the position and magnitude data of the VSWR into real and imaginary parts. I/Q plot data may mean data displaying information on a specific signal using an orthogonal coordinate system and a complex number coordinate system. An x-axis of I/Q plot data may include an in-phase (I) channel as a real part of a signal. A y-axis of I/Q plot data may include a quadrature phase (Q channel) as an imaginary part of a signal. The communication processor 301 may determine whether to change the reference voltage Vref based on I/Q plot data corresponding to the VSWR. According to an example, the communication processor 301 may determine to change (or decrease) the reference voltage based on the VSWR being equal to or greater than (or exceeding) a designated value. A process in which the communication processor 301 changes the reference voltage Vref based on I/Q plot data will be described with reference to FIG. 6.

In an embodiment, the communication processor 301 may change the reference voltage Vref by a method of changing the magnitude of the variable resistors 411 and 412 based on the determination to change the reference voltage. The first variable resistor 411 may be electrically connected between a voltage input terminal of the battery and an operation amplifier. The second variable resistor 412 may be electrically connected between the collector voltage input terminal and the operation amplifier. As the communication processor 301 determines to decrease the reference voltage, the communication processor 301 may increase the magnitude of the variable resistors 411 and 412. The variable resistors 411 and 412 may be implemented into a combination of a passive element (R) and/or an active element (MOSFET or BJT). The communication processor 301 may control the possibility of occurrence of damage to be low by changing the reference voltage Vref in a situation in which the VSWR exceeds a designated level and in which the possibility of occurrence of damage is thus high.

FIG. 5 is a diagram illustrating an amplifier circuit in an electronic device according to an embodiment.

With reference to FIG. 5, an amplifier circuit (e.g., the amplifier circuit 311 of FIG. 3) according to an embodiment may include a first port 511 for receiving an input of a signal to be amplified, a second port 513 for receiving a bias voltage, a third port 515 for receiving a voltage from a first power supply circuit (e.g., the power supply circuit 340 of FIG. 4), and/or a fourth port 517 for outputting an amplified signal.

The amplifier circuit 311 illustrated in FIG. 5 is illustrated with a symbol of a bipolar junction transistor (BJT), but the amplifier circuit 311 of the disclosure may be implemented into various elements (e.g., field effect transistor (FET)) capable of amplifying a signal and a combination of elements as well as a BJT.

According to an embodiment, the first port 511 may be electrically connected to a transceiver (e.g., the transceiver 303 of FIG. 3). The fourth port 517 may be electrically connected to an antenna (e.g., the antenna 330 of FIG. 3).

According to an embodiment, the amplifier circuit 311 may be electrically connected to various elements 519 according to a designer's intention. For example, various elements 519 may include a passive element (resistor, inductor, or capacitor) and/or an active element, and be used for determining a power gain of the amplifier circuit 311.

According to an embodiment, the electronic device (e.g., the electronic device 101 of FIG. 1) or the communication processor (e.g., the communication processor 301 of FIG. 3) may identify the intensity of a signal to be output, and determine the magnitude of the voltage to be applied through the second port 513 and the magnitude of the voltage to be applied through the third port 515.

According to an embodiment, the electronic device (e.g., the electronic device 101 of FIG. 1) may determine a magnitude (e.g., 3V) of a voltage to be applied through the third port 515 and control a power supply circuit to apply the determined voltage. The electronic device 101 may determine the magnitude of a bias voltage to be applied through the second port 513 and apply the determined voltage to the amplifier circuit 311. The electronic device 101 may apply the determined voltage to the amplifier circuit 311 by a method of directly applying a bias voltage to the second port 513 through a control signal path connected through the transceiver 303.

FIG. 6 illustrates I/Q plot data corresponding to a VSWR of an electronic device according to an embodiment.

According to an embodiment, the communication processor (e.g., the communication processor 301 of FIG. 3) may acquire information on a VSWR, which is a ratio between the intensity of a signal output to the antenna 330 and the intensity of a signal reflected without being transmitted to the antenna 330 when the signal is transmitted to the antenna 330 using the coupler (e.g., the coupler 320 of FIG. 3). According to an example, the communication processor 301 may identify the intensity of the reflected signal acquired using the coupler 320. The communication processor 301 may receive the intensity of the amplified signal from the amplifier circuit 311. The communication processor 301 may identify the VSWR based on a ratio between the intensity of the amplified signal and the intensity of the reflected signal. Information on the VSWR may be converted into I/Q plot data displayed by dividing the position and magnitude data of the VSWR into real and imaginary parts. I/Q plot data may mean data displaying information on a specific signal using an orthogonal coordinate system and a complex number coordinate system. An x-axis of I/Q plot data may include an in-phase (I) channel as a real part of a signal. A y-axis of I/Q plot data may include a quadrature phase (Q channel) as an imaginary part of a signal. The communication processor 301 may determine whether to change the reference voltage Vref based on I/Q plot data corresponding to the VSWR. According to an example, the communication processor 301 may determine to change (or decrease) the reference voltage based on the VSWR being equal to or greater than (or exceeding) a designated value.

In FIG. 6, the magnitude of the VSWR may be determined as a distance between an origin 601 and a point corresponding to the signal 605. The signal 605 may mean a signal output to the antenna 330 but reflected without reaching the antenna 330. The position of the signal 605 may be determined differently according to a frequency band of the amplifier circuit 311. The number or position of the signal 605 is just an example and may vary according to the situation of the amplifier circuit 311, but it is not limited thereto. The communication processor 301 may measure a reflected wave reflected by an antenna among signals output by the amplifier using the coupler 320 and identify the VSWR. The communication processor 301 may determine whether a position of a signal corresponding to a VSWR is positioned inside a designated area 610 on the I/Q plot chart of FIG. 6. The communication processor 301 may maintain the reference voltage Vref at which the OVP circuit (e.g., the OVP circuit 400 of FIG. 4) operates at a designated level (e.g., 4.5V) based on the position of the signal corresponding to the VSWR being positioned inside the designated area 610. The communication processor 301 may lower the reference voltage Vref at which the OVP circuit 400 operates to a designated level (e.g., 3.8 V) based on the position of the signal corresponding to the VSWR being positioned inside the designated area 610. For example, the processor 301 may determine that the position of the signal corresponding to the VSWR is positioned outside the designated area 610 based on the position of the signal corresponding to the VSWR being positioned at the first point 607. The processor 301 may lower the reference voltage Vref at which the OVP circuit 400 operates to a designated level (e.g., 3.8V) based on the position of the signal corresponding to the VSWR being positioned outside the designated area 610. The communication processor 301 may control the possibility of occurrence of damage to be low by lowering the reference voltage Vref at which the OVP circuit 400 operates in a situation in which the VSWR is relatively high and in which the risk of damage is thus relatively high. The position of the designated area 610 is not fixed, and may be determined differently based on at least one of the magnitude of power input to the amplifier or the magnitude or configuration of the voltage Vcc applied to the collector terminal.

The designated area 610 may mean a value of a frequency band of the amplifier circuit 311. The magnitude and position of the designated area 610 may be determined differently according to the frequency supported by the amplifier circuit 311. Information on the magnitude and position of the designated area 610 may be acquired from a manufacturer of the amplifier circuit 311 or may be created through a test in the electronic device (e.g., the electronic device 101 of FIG. 1). In FIG. 6, the designated area 610 to be a reference for the voltage magnitude control is illustrated as an area on a complex plane, but the designated area 610 is not limited to an area on the complex plane. For example, the designated area 610 may be displayed as a numerical range on coordinates or in the form of a lookup table. In an embodiment, the communication processor 301 may change the reference voltage Vref by a method of changing the magnitude of the variable resistor (e.g., the variable resistors 411 and 412 of FIG. 4) based on the determination to change the reference voltage. The first variable resistor 411 may be electrically connected between a voltage input terminal of the battery and the operation amplifier. The second variable resistor 412 may be electrically connected between a collector voltage input terminal and the operation amplifier. As the communication processor 301 determines to decrease the reference voltage, the communication processor 301 may increase the magnitude of the variable resistors 411 and 412. The variable resistors 411 and 412 may be implemented into a combination of a passive element (R) and/or an active element (MOSFET or BJT). The communication processor 301 may control the possibility of occurrence of damage to be low by changing the reference voltage Vref in a situation in which the VSWR exceeds a designated level and in which the possibility of occurrence of damage is thus high.

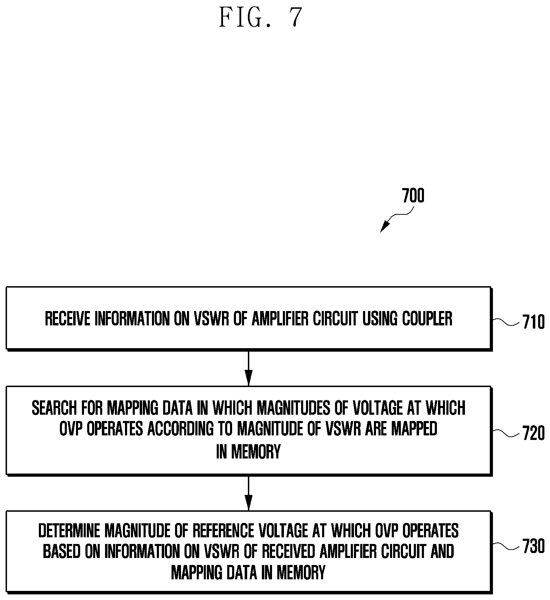

FIG. 7 is a flowchart illustrating a method of controlling an amplifier circuit of an electronic device according to an embodiment.

Operations described with reference to FIG. 7 may be implemented based on instructions that may be stored in a computer recording medium or memory (e.g., the memory 130 of FIG. 1). An illustrated method 700 may be executed by the electronic device (e.g., the electronic device 101 of FIG. 1) previously described with reference to FIGS. 1 to 6, and technical features described above will be omitted below. The order of each operation in FIG. 7 may be changed, some operations may be omitted, or some operations may be performed simultaneously.

In operation 710, the communication processor (e.g., the communication processor 301 of FIG. 3) may acquire information on a VSWR, which is a ratio between the intensity of a signal output to the antenna 330 and the intensity of the signal reflected without being transferred to the antenna 330 when the signal is transmitted to the antenna 330 using the coupler 320. The communication processor may receive information on the VSWR of the amplifier circuit 311. According to an example, the communication processor 301 may identify the intensity of the reflected signal acquired using the coupler 320. The communication processor 301 may receive the intensity of the amplified signal from the amplifier circuit 311. The communication processor 301 may identify the VSWR based on a ratio between the intensity of the amplified signal and the intensity of the reflected signal. The coupler 320 is a passive element and may be used for measuring the magnitude of the VSWR of the amplifier circuit 311. The coupler 320 may be used for distributing one signal power into a plurality of specific signal powers or may be used for extracting some of specific signal power. The voltage standing wave may mean a wave observed as only oscillating in place without moving left and right by a combination of an incident wave and a reflected wave. The VSWR may mean an amplitude ratio between a maximum point and a minimum point of an oscillating voltage standing wave. The VSWR may mean a height ratio of a voltage standing wave generated by partially reflecting when a signal is output to an antenna. The VSWR of the antenna terminal may mean the degree to which a signal is reflected back without being transmitted to the antenna when a signal is input to the antenna. As the VSWR of the antenna terminal increases, the effect of the reflected wave on the output of the antenna may increase relatively. As the VSWR increases, the possibility of occurrence of damage due to the effect of the reflected wave may relatively increase.

In operation 720, the communication processor 301 may search for mapping data in which magnitudes of a voltage at which the OVP operates according to the magnitude of the VSWR are mapped in the memory 130. Mapping data may be determined based on I/Q plot data corresponding to the VSWR of FIG. 6.

In operation 730, the communication processor 301 may determine the magnitude of the reference voltage Vref at which the OVP device operates based on information on the VSWR of the signal output to the antenna and mapping data in the memory 130. The magnitude of the reference voltage Vref can be a preset value.

In an embodiment, the communication processor 301 may maintain a reference voltage Vref in which an OVP circuit (e.g., the OVP circuit 400 of FIG. 4) operates at a designated level (e.g., 4.5V) based on the position of the signal corresponding to the VSWR being positioned within the designated area (e.g., the designated area 610 of FIG. 6). The communication processor 301 may lower the reference voltage Vref at which the OVP circuit 400 operates to a designated level (e.g., 3.8V) based on the position of the signal corresponding to the VSWR being positioned outside the designated area. The communication processor 301 may control the possibility of occurrence of damage to be low by lowering the reference voltage Vref at which the OVP circuit 400 operates in a situation in which the VSWR is relatively high and in which the risk of occurrence of damage is thus relatively high.

In an embodiment, the communication processor 301 may change the reference voltage Vref by a method of changing the magnitude of variable resistors (e.g., the variable resistors 411 and 412 of FIG. 4) based on the determination to change the reference voltage. As the communication processor 301 determines to decrease the reference voltage, the communication processor 301 may increase the magnitude of the variable resistors 411 and 412. The variable resistors 411 and 412 may be implemented into a combination of a passive element (R) and/or an active element (MOSFET or BJT). The communication processor 301 may control the possibility of occurrence of damage to be low by changing the reference voltage Vref in a situation in which the VSWR exceeds a designated level and in which the possibility of occurrence of damage is high.

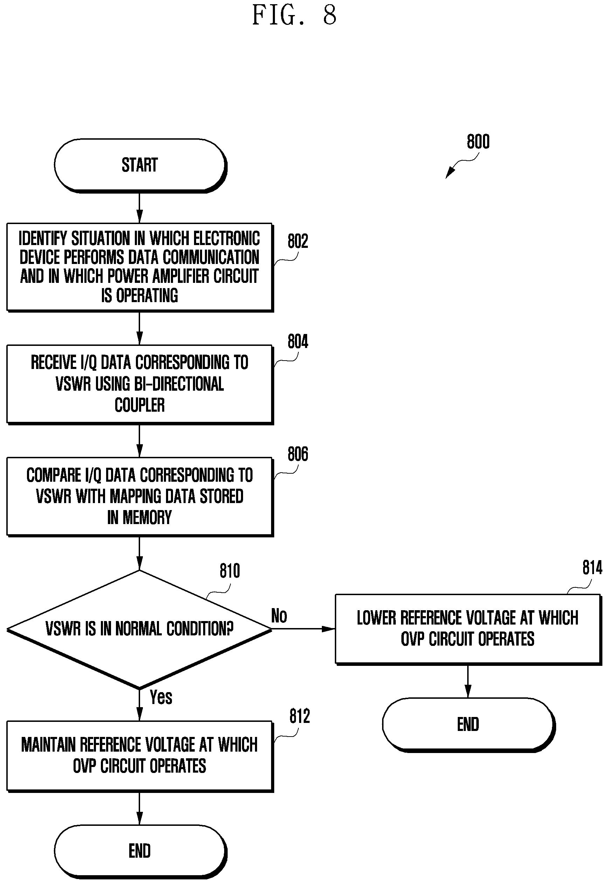

FIG. 8 is a flowchart illustrating a method of controlling an amplifier circuit of an electronic device according to an embodiment.

Operations described with reference to FIG. 8 may be implemented based on instructions that may be stored in a computer recording medium or memory (e.g., the memory 130 of FIG. 1). An illustrated method 800 may be executed by the electronic device (e.g., the electronic device 101 of FIG. 1) previously described with reference to FIGS. 1 to 6, and technical features described above will be omitted below. The order of each operation in FIG. 8 may be changed, some operations may be omitted, or some operations may be performed simultaneously.

In operation 802, the communication processor (e.g., the communication processor 301 of FIG. 3) may identify a situation in which the electronic device 101 performs data communication and in which the amplifier circuit (e.g., the amplifier circuit 311 of FIG. 3) is operating.

In operation 804, the communication processor 301 may receive I/Q data corresponding to the VSWR using a bi-directional coupler. According to an embodiment, the communication processor 301 may acquire information on the VSWR, which is a ratio between the intensity of a signal output to the antenna 330 and the intensity of a signal reflected without being transmitted to the antenna 330 when the signal is transmitted to the antenna 330 using the coupler 320. According to an example, the communication processor 301 may identify the intensity of the reflected signal acquired using the coupler 320. The communication processor 301 may receive the intensity of the amplified signal from the amplifier circuit 311. The communication processor 301 may identify the VSWR based on a ratio between the intensity of the amplified signal and the intensity of the reflected signal. The coupler 320 is a passive element and may be used for measuring the magnitude of the VSWR of the amplifier circuit 311. I/Q data corresponding to the VSWR may include I/Q plot data displayed by dividing the position and magnitude data of the VSWR into real and imaginary parts. I/Q plot data may mean data displaying information on a specific signal using an orthogonal coordinate system and a complex number coordinate system. An x-axis of I/Q plot data may include an in-phase (I) channel as a real part of a signal. A y-axis of I/Q plot data may include a quadrature phase (Q channel) as an imaginary part of a signal. I/Q plot data have been described with reference to FIG. 6.

In operation 806, the communication processor 301 may compare I/Q data corresponding to the VSWR with mapping data stored in the memory 130. Mapping data may be determined based on I/Q plot data corresponding to the VSWR of FIG. 6.

In operation 810, the communication processor 301 may determine whether the VSWR is in a normal condition. The normal condition may mean a situation in which a position of a signal corresponding to the VSWR is positioned inside a designated area 610 (e.g., the designated area 610 of FIG. 6). An abnormal condition may mean a situation in which a position of a signal corresponding to the VSWR is positioned outside the designated area 610. The position of the designated area 610 is not fixed, and may be determined differently based on at least one of the magnitude of power input to the amplifier or the magnitude or configuration of the voltage Vcc applied to a collector terminal.

In operation 812, the communication processor 301 may maintain a reference voltage Vref at which the OVP circuit (e.g., the OVP circuit 400 of FIG. 4) operates at a designated level (e.g., 4.5V) based on the VSWR of the signal output to the antenna being in a normal condition. Alternatively, the communication processor 301 may maintain the reference voltage Vref at which the OVP circuit 400 operates in a designated level (e.g., 4.5V) based on the position of the signal corresponding to the VSWR being positioned inside the designated area 610.

In operation 814, the communication processor 301 may lower the reference voltage Vref at which the OVP circuit 400 operates to a designated level (e.g., 3.8V) based on the VSWR of the signal output to the antenna being in an abnormal condition. Alternatively, the communication processor 301 may lower the reference voltage Vref at which the OVP circuit 400 operates to a designated level (e.g., 3.8V) based on the position of the signal corresponding to the VSWR being positioned outside the designated area 610. The communication processor 301 may control the possibility of occurrence of damage to be low by lowering the reference voltage Vref at which the voltage protection circuit operates in a situation in which the VSWR is relatively high and in which the risk of occurrence of damage is thus relatively high.

## Claims

1. An electronic device (101), comprising:
an amplifier circuit (311) configured to amplify a signal of a specific frequency band;
an overvoltage protection, 'OVP', circuit (400) configured to reduce a voltage applied to the amplifier circuit (311) when a battery voltage of a battery of the electronic device and/or a supply voltage applied to the amplifier circuit (311) is greater than or equal to a reference voltage;
a coupler (320) configured to acquire a part of a signal output from the amplifier circuit (311) to an antenna (330);
a memory (130); and
a communication processor (301) operatively connected with the amplifier circuit (311) and the memory (130),
wherein the communication processor (301) is configured to:
receive, using the coupler (320), information on a voltage standing wave ratio, 'VSWR', of the signal output to the antenna (330),
determine, based on mapping data stored in the memory (130) in which magnitudes of the VSWR and magnitudes of the reference voltage at which the OVP circuit (400) operates are mapped, a magnitude of the reference voltage corresponding to the VSWR, and
control the OVP circuit (400) according to the determined magnitude of the reference voltage.

2. The electronic device (101) of claim 1, wherein the communication processor (301) is further configured to adjust the reference voltage at which the OVP circuit (400) operates using a variable resistor based on the determined magnitude of the reference voltage.

3. The electronic device (101) of claim 1 or 2, wherein the communication processor (301) is further configured to:
determine the reference voltage at which the OVP circuit (400) operates to have a first magnitude based on the VSWR of the signal output to the antenna (330) exceeding a designated value, and
determine the reference voltage at which the OVP circuit (400) operates to have a value higher than the first magnitude or determine not to change the reference voltage at which the OVP circuit (400) operates based on the VSWR of the signal output to the antenna (330) being less than the designated value.

4. The electronic device (101) of any of the previous claims, wherein the communication processor (301) is further configured to determine whether to change the reference voltage based on I/Q plot data indicating an area in which a position of a signal corresponding to the VSWR is determined to be in a designated condition.

5. The electronic device (101) of claim 4, wherein the magnitude of the VSWR is determined by a distance from an origin to a position in which the signal corresponding to the VSWR is displayed in the I/Q plot data.

6. The electronic device (101) of claim 4 or 5, wherein the communication processor (301) is further configured to maintain the reference voltage at which the OVP circuit operates based on the position of the signal corresponding to the VSWR satisfying the designated condition in the I/Q plot data.

7. The electronic device (101) according to any of the claims 4-6, wherein, in the mapping data, the reference voltage for determining whether to cut off an operation of the OVP circuit (400) is mapped according to whether the position of the signal corresponding to the VSWR satisfies the designated condition in the I/Q plot data.

8. The electronic device (101) of claim 4-7, wherein the communication processor (301) is further configured to control to lower the reference voltage at which the OVP circuit (400) operates to a designated level based on the position of the signal corresponding to the VSWR being positioned outside a designated area in the I/Q plot data.

9. The electronic device (101) of claim 8, wherein the designated area is determined differently based on at least one of:
a magnitude of power input to the amplifier circuit (311);
a magnitude or configuration of a voltage Vcc applied to a collector terminal; and
a frequency supported by the amplifier circuit (311).

10. The electronic device (101) of any of the previous claims, wherein the mapping data includes a table in which magnitudes of the VSWR and magnitudes of the reference voltage at which the OVP circuit (400) operates are mapped.

11. A method of operating an electronic device, comprising:
receiving (710) information on a voltage standing wave ratio, 'VSWR', of a signal output to an antenna using a coupler configured to acquire a part of the signal output from the amplifier circuit to the antenna;
determining (720), based on mapping data stored in a memory in which magnitudes of the VSWR and magnitudes of a reference voltage at which an overvoltage protection, 'OVP', circuit operates are mapped, a magnitude of the reference voltage corresponding to the VSWR; and
controlling (730) the OVP circuit according to the determined magnitude of the reference voltage to reduce a voltage applied to the amplifier circuit when a battery voltage of a battery of the electronic device and/or a supply voltage applied to the amplifier circuit is greater than or equal to the reference voltage.

12. The method of claim 11,
wherein controlling the OVP circuit according to the determined magnitude of the reference voltage further comprises adjusting the reference voltage at which the OVP circuit operates using a variable resistor.

13. The method of claim 11, wherein determining the magnitude of the reference voltage Vref corresponding to the VSWR further comprises:
determining (814) the reference voltage at which the OVP circuit operates to have a first magnitude based on the VSWR of the signal output to the antenna exceeding a designated value; and
determining the reference voltage at which the OVP circuit operates to have a value higher than the first magnitude or determining (812) not to change the reference voltage at which the OVP circuit operates based on the VSWR of the signal output to the antenna being less than the designated value;
and/or
wherein the mapping data includes a table in which magnitudes of the VSWR and magnitudes of the reference voltage at which the OVP circuit operates are mapped.

14. The method of claim 11 or 12, wherein determining a magnitude of the reference voltage corresponding to the VSWR further comprises determining whether to change the reference voltage based on I/Q plot data indicating an area in which a position of a signal corresponding to the VSWR is determined to be in a designated condition.

15. The method of claim 14, wherein the magnitude of the VSWR is determined by a distance from an origin and a position in which a signal corresponding to the VSWR is displayed in the I/Q plot data.

## Patentansprüche

1. Elektronische Vorrichtung (101), die Folgendes umfasst:
eine Verstärkerschaltung (311), die so konfiguriert ist, dass sie ein Signal eines spezifischen Frequenzbandes verstärkt;
eine Überspannungsschutzschaltung (OVP-Schaltung, Overvoltage Protection) (400), die so konfiguriert ist, dass sie eine an die Verstärkerschaltung (311) angelegte Spannung verringert, wenn eine Batteriespannung einer Batterie der elektronischen Vorrichtung und/oder eine an die Verstärkerschaltung (311) angelegte Versorgungsspannung größer oder gleich einer Referenzspannung ist;
einen Koppler (320), der so konfiguriert ist, dass er einen Teil eines von der Verstärkerschaltung (311) an eine Antenne (330) ausgegebenen Signals erhält;
einen Speicher (130); und
einen Kommunikationsprozessor (301), der betriebsmäßig mit der Verstärkerschaltung (311) und dem Speicher (130) verbunden ist,
wobei der Kommunikationsprozessor (301) zu Folgendem konfiguriert ist:
Empfangen von Informationen über ein Spannungsstehwellenverhältnis (VSWR, Voltage Standing Wave Ratio) des an die Antenne (330) ausgegebenen Signals unter Verwendung des Kopplers (320),
Bestimmen einer Größe der dem VSWR entsprechenden Referenzspannung basierend auf in dem Speicher (130) gespeicherten Abbildungsdaten, in denen Größen des VSWR und Größen der Referenzspannung, bei der die OVP-Schaltung (400) betrieben wird, abgebildet sind, und
Steuern der OVP-Schaltung (400) gemäß der bestimmten Größe der Referenzspannung.

2. Elektronische Vorrichtung (101) nach Anspruch 1, wobei der Kommunikationsprozessor (301) ferner so konfiguriert ist, dass er die Referenzspannung, bei der die OVP-Schaltung (400) betrieben wird, unter Verwendung eines variablen Widerstands basierend auf der bestimmten Größe der Referenzspannung anpasst.

3. Elektronische Vorrichtung (101) nach Anspruch 1 oder 2, wobei der Kommunikationsprozessor (301) ferner zu Folgendem konfiguriert ist:
Bestimmen der Referenzspannung, bei der die OVP-Schaltung (400) betrieben wird, auf eine erste Größe basierend darauf, dass das VSWR des an die Antenne (330) ausgegebenen Signals einen vorgesehenen Wert übersteigt, und
Bestimmen der Referenzspannung, bei der die OVP-Schaltung (400) betrieben wird, auf einen Wert, der höher ist als die erste Größe, oder Bestimmen, die Referenzspannung, bei der die OVP-Schaltung (400) betrieben wird, nicht zu ändern, basierend darauf, dass das VSWR des an die Antenne (330) ausgegebenen Signals kleiner ist als der vorgesehene Wert.

4. Elektronische Vorrichtung (101) nach einem der vorhergehenden Ansprüche, wobei der Kommunikationsprozessor (301) ferner so konfiguriert ist, dass er bestimmt, ob die Referenzspannung geändert werden soll, und zwar basierend auf I/Q-Diagrammdaten, die einen Bereich angeben, in dem eine Position eines dem VSWR entsprechenden Signals als in einem vorgesehenen Zustand befindlich bestimmt wird.

5. Elektronische Vorrichtung (101) nach Anspruch 4, wobei die Größe des VSWR durch einen Abstand von einem Ursprung zu einer Position bestimmt wird, an der das dem VSWR entsprechende Signal in den I/Q-Diagrammdaten angezeigt wird.

6. Elektronische Vorrichtung (101) nach Anspruch 4 oder 5, wobei der Kommunikationsprozessor (301) ferner so konfiguriert ist, dass er die Referenzspannung, bei der die OVP-Schaltung betrieben wird, aufrechterhält, und zwar basierend darauf, dass die Position des dem VSWR entsprechenden Signals die vorgesehene Bedingung in den I/Q-Diagrammdaten erfüllt.

7. Elektronische Vorrichtung (101) nach einem der Ansprüche 4 bis 6, wobei in den Abbildungsdaten die Referenzspannung zum Bestimmen, ob ein Betrieb der OVP-Schaltung (400) unterbrochen werden soll, danach abgebildet wird, ob die Position des dem VSWR entsprechenden Signals, die vorgesehene Bedingung in den I/Q-Diagrammdaten erfüllt.

8. Elektronische Vorrichtung (101) nach den Ansprüchen 4 bis 7, wobei der Kommunikationsprozessor (301) ferner so konfiguriert ist, dass er eine Steuerung durchführt, bei der die Referenzspannung, bei der die OVP-Schaltung (400) betrieben wird, auf einen vorgesehenen Pegel verringert wird, basierend darauf, dass die Position des dem VSWR entsprechenden Signals außerhalb eines vorgesehenen Bereichs in den I/Q-Diagrammdaten liegt.

9. Elektronische Vorrichtung (101) nach Anspruch 8, wobei der vorgesehene Bereich unterschiedlich bestimmt wird, basierend auf zumindest einem der folgenden Faktoren:
einer Größe der Leistung, die in die Verstärkerschaltung (311) eingegeben wird;
einer Größe oder Konfiguration einer Spannung Vcc, die an einen Kollektoranschluss angelegt wird; und
einer Frequenz, die von der Verstärkerschaltung (311) unterstützt wird.

10. Elektronische Vorrichtung (101) nach einem der vorhergehenden Ansprüche, wobei die Abbildungsdaten eine Tabelle beinhalten, in der die Größen des VSWR und die Größen der Referenzspannung, bei der die OVP-Schaltung (400) betrieben wird, abgebildet sind.

11. Verfahren zum Betrieb einer elektronischen Vorrichtung, das Folgendes umfasst:
Empfangen (710) von Informationen über ein Spannungsstehwellenverhältnis (VSWR, Voltage Standing Wave Ratio) eines an eine Antenne ausgegebenen Signals unter Verwendung eines Kopplers, der so konfiguriert ist, dass er einen Teil des von der Verstärkerschaltung an die Antenne ausgegebenen Signals erhält;
Bestimmen (720) einer Größe der dem VSWR entsprechenden Referenzspannung basierend auf in einem Speicher gespeicherten Abbildungsdaten, in denen Größen des VSWR und Größen einer Referenzspannung, bei der eine Überspannungsschutzschaltung (OVP-Schaltung, Overvoltage Protection) betrieben wird, abgebildet sind; und
Steuern (730) der OVP-Schaltung gemäß der bestimmten Größe der Referenzspannung, um eine an die Verstärkerschaltung angelegte Spannung zu verringern, wenn eine Batteriespannung einer Batterie der elektronischen Vorrichtung und/oder eine an die Verstärkerschaltung angelegte Versorgungsspannung größer oder gleich der Referenzspannung ist.

12. Verfahren nach Anspruch 11, wobei das Steuern der OVP-Schaltung gemäß der bestimmten Größe der Referenzspannung ferner das Anpassen der Referenzspannung umfasst, bei der die OVP-Schaltung betrieben wird, und zwar unter Verwendung eines variablen Widerstands.

13. Verfahren nach Anspruch 11, wobei das Bestimmen der Größe der dem VSWR entsprechenden Referenzspannung Vref ferner Folgendes umfasst:
Bestimmen (814) der Referenzspannung, bei der die OVP-Schaltung betrieben wird, auf eine erste Größe basierend darauf, dass das VSWR des an die Antenne ausgegebenen Signals einen vorgesehenen Wert überschreitet; und
Bestimmen der Referenzspannung, bei der die OVP-Schaltung betrieben wird, auf einen Wert, der höher ist als die erste Größe, oder Bestimmen (812), die Referenzspannung, bei der die OVP-Schaltung betrieben wird, nicht zu ändern, basierend darauf, dass das VSWR des an die Antenne ausgegebenen Signals kleiner ist als der vorgesehene Wert; und/oder
wobei die Abbildungsdaten eine Tabelle beinhalten, in der die Größen des VSWR und die Größen der Referenzspannung, bei der die OVP-Schaltung betrieben wird, abgebildet sind.

14. Verfahren nach Anspruch 11 oder 12, wobei das Bestimmen einer Größe der dem VSWR entsprechenden Referenzspannung ferner das Bestimmen umfasst, ob die Referenzspannung geändert werden soll, und zwar basierend auf I/Q-Diagrammdaten, die einen Bereich angeben, in dem eine Position eines dem VSWR entsprechenden Signals als in einem vorgesehenen Zustand befindlich bestimmt wird.

15. Verfahren nach Anspruch 14, wobei die Größe des VSWR durch einen Abstand von einem Ursprung zu einer Position bestimmt wird, an der ein dem VSWR entsprechendes Signal in den I/Q-Diagrammdaten angezeigt wird.

## Revendications

1. Dispositif électronique (101) comprenant :
un circuit amplificateur (311) configuré pour amplifier un signal d'une bande de fréquence donnée, un circuit de protection contre les surtensions (OVP, overvoltage protection) (400) configuré pour réduire une tension appliquée au circuit amplificateur (311) lorsque la tension d'une batterie du dispositif électronique et/ou une tension d'alimentation appliquée au circuit amplificateur (311) est supérieure ou égale à une tension de référence,
un coupleur (320) configuré pour acquérir une partie d'un signal émis par le circuit amplificateur (311) à destination d'une antenne (330),
une mémoire (130), et
un processeur de communication (301) relié fonctionnellement au circuit amplificateur (311) et à la mémoire (130) ;
ledit processeur de communication (301) étant configuré pour :
recevoir, à l'aide du coupleur (320), des informations sur le rapport d'ondes stationnaires (ROS ou VSWR pour Voltage standing wave ratio) du signal émis à destination de l'antenne (330),
déterminer une grandeur de la tension de référence correspondant au ROS, en fonction de données de correspondance stockées dans la mémoire (130) et dans lesquelles sont mises en correspondance les grandeurs du ROS et les grandeurs de la tension de référence à laquelle fonctionne le circuit OVP (400), et
commander le circuit OVP (400) en fonction de la grandeur de la tension de référence déterminée.

2. Dispositif électronique (101) selon la revendication 1, dans lequel le processeur de communication (301) est en outre configuré pour régler la tension de référence à laquelle le circuit OVP (400) fonctionne à l'aide d'une résistance variable en fonction de la grandeur de la tension de référence déterminée.

3. Dispositif électronique (101) selon la revendication 1 ou 2, dans lequel le processeur de communication (301) est en outre configuré pour :
déterminer la tension de référence à laquelle le circuit OVP (400) fonctionne de façon qu'elle ait une première grandeur en fonction du fait que le ROS du signal émis à destination de l'antenne (330) dépasse une valeur spécifique, et
déterminer la tension de référence à laquelle le circuit OVP (400) fonctionne de façon qu'elle ait une valeur supérieure à la première grandeur ou déterminer ne pas modifier la tension de référence à laquelle le circuit OVP (400) fonctionne en fonction du fait que le ROS du signal émis à destination de l'antenne (330) est inférieur à ladite valeur spécifique.

4. Dispositif électronique (101) selon l'une quelconque des revendications précédentes, dans lequel le processeur de communication (301) est en outre configuré pour déterminer la nécessité ou non de modifier la tension de référence en fonction de données de représentation I/Q indiquant une zone dans laquelle la position d'un signal correspondant au ROS est déterminée comme étant dans une situation spécifique.

5. Dispositif électronique (101) selon la revendication 4, dans lequel la grandeur du ROS est déterminée par une distance entre une origine et la position à laquelle le signal correspondant au ROS est affiché dans les données de représentation I/Q.

6. Dispositif électronique (101) selon la revendication 4 ou 5, dans lequel le processeur de communication (301) est en outre configuré pour maintenir la tension de référence à laquelle le circuit OVP fonctionne en fonction du fait que la position du signal correspondant au VSWR satisfait à la situation spécifique dans les données de représentation I/Q.

7. Dispositif électronique (101) selon l'une quelconque des revendications 4 à 6, dans lequel, dans les données de correspondance, la tension de référence servant à déterminer la nécessité ou non d'interrompre le fonctionnement du circuit OVP (400) est mise en correspondance selon que la position du signal correspondant au ROS satisfait à la situation spécifique dans les données de représentation I/Q.

8. Dispositif électronique (101) selon les revendications 4 à 7, dans lequel le processeur de communication (301) est en outre configuré pour commander la baisse de la tension de référence à laquelle le circuit OVP (400) fonctionne à un niveau spécifique en fonction du fait que la position du signal correspondant au ROS se situe en dehors d'une zone spécifique dans les données de représentation I/Q.

9. Dispositif électronique (101) selon la revendication 8, dans lequel la zone spécifique est déterminée différemment en fonction d'au moins un des critères suivants :
la grandeur de la puissance fournie au circuit amplificateur (311),
la grandeur ou la configuration d'une tension Vcc appliquée à une borne de collecteur, et
la fréquence prise en charge par le circuit amplificateur (311).

10. Dispositif électronique (101) selon l'une quelconque des revendications précédentes, dans lequel les données de correspondance comprennent un tableau dans lequel sont mises en correspondance les grandeurs du ROS et les grandeurs de la tension de référence à laquelle le circuit OVP (400) fonctionne.

11. Procédé d'exploitation d'un dispositif électronique, comprenant :
la réception (710) d'informations sur le rapport d'ondes stationnaires (ROS ou VSWR pour Voltage standing wave ratio) d'un signal émis à destination d'une antenne, à l'aide d'un coupleur configuré pour acquérir une partie du signal émis par le circuit amplificateur vers l'antenne ;
la détermination (720) d'une grandeur de la tension de référence correspondant au ROS, en fonction de données de correspondance stockées dans une mémoire et dans lesquelles sont mises en correspondance les grandeurs du ROS et les grandeurs d'une tension de référence à laquelle fonctionne un circuit de protection contre les surtensions (OVP, overvoltage protection) ; et
la commande (730) du circuit OVP en fonction de la grandeur de la tension de référence déterminée pour réduire une tension appliquée au circuit amplificateur lorsque la tension d'une batterie d'un dispositif électronique et/ou la tension d'alimentation appliquée au circuit amplificateur est supérieure ou égale à la tension de référence.

12. Procédé selon la revendication 11, dans lequel la commande du circuit OVP en fonction de la grandeur de la tension de référence déterminée comprend en outre le réglage de la tension de référence à laquelle le circuit OVP fonctionne à l'aide d'une résistance variable.

13. Procédé selon la revendication 11, dans lequel la détermination de la grandeur de la tension de référence Vref correspondant au ROS comprend en outre :
la détermination (814) de la tension de référence à laquelle le circuit OVP fonctionne de façon qu'elle ait une première grandeur compte tenu du fait que le ROS du signal émis à destination de l'antenne dépasse une valeur spécifique, et
la détermination de la tension de référence à laquelle le circuit OVP fonctionne de façon qu'elle ait une valeur supérieure à la première grandeur ou la détermination (812) de ne pas modifier la tension de référence à laquelle le circuit OVP fonctionne en fonction du fait que le ROS du signal émis à destination de l'antenne est inférieur à ladite valeur spécifique ; et/ou
dans lequel les données de mise en correspondance comprennent un tableau dans lequel les grandeurs du ROS et les grandeurs de la tension de référence à laquelle le circuit OVP fonctionne sont mises en correspondance.

14. Procédé selon la revendication 11 ou 12, dans lequel la détermination de la grandeur de la tension de référence correspondant au ROS comprend en outre la détermination de la nécessité ou non de modifier la tension de référence en fonction de données de représentation I/Q indiquant une zone dans laquelle la position d'un signal correspondant au ROS est déterminée comme étant dans une situation spécifique.

15. Procédé selon la revendication 14, dans lequel la grandeur du ROS est déterminée par une distance entre une origine et la position à laquelle un signal correspondant au ROS est affiché dans les données de représentation I/Q.
